# EUROPEAN PATENT APPLICATION

(11) **EP 2 508 654 A1**
(43) Date of publication of application: **10.10.2012**
(21) Application number: 12004939.0
(22) Date of filing: 03.11.2010
(51) Int. Cl.: C30B 25/14, C30B 29/40, C23C 16/54, C23C 16/455

(54) **Vapor deposition system**

(30) Priority: 12.02.2010 KR 20100013545
(62) Divisional of application: 10189828.6
(71) Applicant: Samsung LED Co., Ltd., Gyunggi-do (KR)
(72) Inventor: Lee, Dong Ju, Suwon-si Gyunggi-do (KR); Shim, Hyun Wook, Suwon Gyunggi-do (KR); Lee, Heon Ho, Seongnam Gyunggi-do (KR); Kim, Young Sun, Suwon Gyunggi-do (KR); Kim, Sung Tae, Seoul (KR)
(74) Representative: Grünecker, Kinkeldey, Stockmair & Schwanhäusser

(57) **Abstract**

There are provided a vapor deposition system, a method of manufacturing a light emitting device, and a light emitting device. A vapor deposition system according to an aspect of the invention may include: a first chamber having a first susceptor and at least one gas distributor discharging a gas in a direction parallel to a substrate disposed on the first susceptor; and a second chamber having a second susceptor and at least one second gas distributor arranged above the second susceptor to discharge a gas downwards.

When a vapor deposition system according to an aspect of the invention is used, a semiconductor layer being thereby grown has excellent crystalline quality, thereby improving the performance of a light emitting device. Furthermore, while the operational capability and productivity of the vapor deposition system are improved, deterioration in an apparatus can be prevented.

## Description

### CROSS-REFERENCE TO RELATED APPLICATIONS

This application claims the priority of Korean Patent Application No. 10-2010-0013545 filed on February 12, 2010, in the Korean Intellectual Property Office, the disclosure of which is incorporated herein by reference.

### BACKGROUND OF THE INVENTION

### Field of the Invention

The present invention relates to a vapor deposition system, a method of manufacturing a light emitting device, and a light emitting device.

### Description of the Related Art

In general, a light emitting diode (LED) is a type of semiconductor light emitting device which emits light of various colors by the recombination of electrons and holes in a p-n junction between a p-type semiconductor and an n-type semiconductor when a current is applied thereto. As this LED has various advantages such as a long life span, low power consumption, good initial driving characteristics, high vibration resistance, and the like, when compared with a light emitting device based on a filament, demand for LEDs continues to increase. In particular, recently, group III nitride semiconductors capable of emitting light in a short-wavelength region, such as a series of blue colors, have come to prominence.

A nitride semiconductor single crystal forming a light emitting device using a group III nitride semiconductor is grown on a sapphire substrate or a SiC substrate. In order to grow this semiconductor single crystal, a vapor deposition process of depositing a plurality of gaseous sources onto a substrate is generally performed. The emission performance or reliability of a semiconductor light emitting device is significantly affected by the quality (crystallinity) of semiconductor layers forming it. In this case, the quality of the semiconductor layers may depend on the structure of a vapor deposition system being used, its internal environment and the conditions of its use. Therefore, in the relevant technical field, there is a need for a method of improving the quality of semiconductor layers by optimizing a vapor deposition process.

### SUMMARY OF THE INVENTION

An aspect of the present invention provides a method of manufacturing a light emitting device using a vapor deposition system that improves the luminous efficiency of a light emitting device by forming a semiconductor layer having an excellent crystalline structure.

An aspect of the present invention also provides a technique for improving the operational capability and productivity of a vapor deposition system.

According to an aspect of the present invention, there is provided a vapor deposition system including: a first chamber having a first susceptor and at least one gas distributor discharging a gas in a direction parallel to a substrate disposed on the first susceptor; and a second chamber having a second susceptor and at least one second gas distributor arranged above the second susceptor to discharge a gas downwards.

According to another aspect of the present invention, there is provided a vapor deposition system including: a first chamber having a first susceptor and at least one gas distributor, the first chamber in which a halide compound gas containing a group III element and a group V element source gas, through the first gas distributor, react on a substrate arranged on the first susceptor to thereby form a semiconductor thin film thereupon; and a second chamber including a second susceptor and at least one second gas distributor, the second chamber in which at least two types of organometallic gases, through the second gas distributor, react on a substrate arranged on the second susceptor to thereby form a semiconductor thin film thereupon.

The vapor deposition system may further include a loadlock apparatus connected to the first and second chambers and having a transfer robot and a transfer path.

The first and second chambers may be provided in a single vapor deposition system.

The first and second chambers may be provided in different vapor deposition systems.

At least one of the first and second chambers may be a batch type chamber.

The first gas distributor may discharge a gas in a direction from an inside to an outside of the first chamber.

The first gas distributor may be arranged in a central region inside the first chamber.

A plurality of substrates may be arranged on the first susceptor, and the plurality of substrates may be arranged into a circle around the first gas distributor.

The first chamber may be an HVPE (hydride vapor phase epitaxy) chamber, and the second chamber may be an MOCVD (metal organic chemical vapor deposition) chamber.

The vapor deposition system may further include a molecular beam epitaxy (MBE) chamber in addition to the first and second chambers.

According to another aspect of the present invention, there is provided a method of manufacturing a light emitting device, the method including growing a first conductive semiconductor layer, an active layer, and a second conductive semiconductor layer on a substrate to thereby form a light emitting structure, wherein when source gases, discharged from above the substrate, react on the substrate to thereby form a semiconductor thin film thereupon in a first process, and the source gases, discharged in a direction parallel to the substrate, react on the substrate to thereby form a semiconductor thin film thereupon in a second process, the light emitting structure is formed using both the first and second processes.

According to another aspect of the present invention, there is provided a method of manufacturing a light emitting device, the method including growing a first conductive semiconductor layer, an active layer, and a second conductive semiconductor layer on a semiconductor growth substrate in a sequential manner to thereby form a light emitting structure, wherein when a halide compound gas containing a group III element and a group V element source gas react on the semiconductor growth substrate to thereby form a semiconductor thin film thereupon in a first process, and two types of organometallic gases react on the semiconductor growth substrate to thereby form a semiconductor thin film thereupon in a second process, the light emitting structure is formed using both the first and second processes.

According to another aspect of the present invention, there is provided a method of manufacturing a light emitting device, the method including growing a first conductive semiconductor layer, an active layer, and a second conductive semiconductor layer on a substrate to thereby form a light emitting structure, wherein a semiconductor thin film is formed using a first vapor deposition system having a first chamber and a first loadlock apparatus in a first process, and a semiconductor thin film is formed using a second vapor deposition system having a second chamber and a second loadlock apparatus in a second process, the light emitting structure is formed using both the first and second processes.

A growth temperature of the first conductive semiconductor layer may be higher than that of the second conductive semiconductor layer.

The active layer may include at least one layer formed of InₓGa₍₁₋ₓ₎N (1≤x≤0).

The active layer may include at least one layer formed of InₓGa₍₁₋ₓ₎P (1≤x≤0).

The first conductive semiconductor layer may include an n-type GaN layer, the active layer may include a lamination structure having alternating InGaN and GaN layers, and the second conductive semiconductor layer may include a p-type GaN layer.

The first conductive semiconductor layer may be formed using the first process.

The active layer and the second conductive semiconductor layer may be formed using the second process.

The first conductive semiconductor layer may be formed using both the first and second processes.

The active layer may be formed using both the first and second processes.

The active layer may include a quantum well layer and a quantum barrier layer, and the quantum well layer and the quantum barrier layer are separately formed using the first and second processes, different from each other.

The first conductive semiconductor layer may be formed using the first process.

The active layer and the second conductive semiconductor layer may be formed using the second process.

The first conductive semiconductor layer may be formed using both the first and second processes.

The light emitting structure may be formed by further using a third process of forming a semiconductor thin film by molecular beam epitaxy.

At least one of the first and second vapor deposition systems may have a batch type chamber in which the substrate is arranged in a thickness direction.

One of the first conductive semiconductor layer, the active layer, and the second conductive semiconductor layer may be grown in the first chamber, another layer may be grown in the second chamber.

The first conductive semiconductor layer may be grown in the first chamber, and the first chamber may be maintained at a growth temperature and a gas atmosphere of the first conductive semiconductor layer.

The active layer and the second conductive layer may be grown in the second chamber, and the second chamber may be maintained at growth temperatures and gas atmospheres of the active layer and the second conductive layer.

The method may further include a third vapor deposition system including a third chamber and a third loadlock apparatus, wherein the first conductive semiconductor layer is grown in the first chamber, the active layer is grown in the second chamber, and the second conductive semiconductor layer is grown in the third chamber.

The first conductive semiconductor layer may be formed using both the first and second processes.

The active layer may be formed using both the first and second processes.

The active layer may include a quantum well layer and a quantum barrier layer, and the quantum well layer and the quantum barrier layer may be separately formed using the first and second processes, different from each other.

According to another aspect of the present invention, there is provided a light emitting device including a light emitting structure having a first conductive semiconductor, an active layer, and a second conductive layer, wherein when source gases, discharged from above a substrate, react on a substrate to thereby form a semiconductor thin film thereupon in a first process, and source gases, discharged in a direction parallel to the substrate, react on the substrate to thereby form a semiconductor thin film thereupon in a second process, the light emitting structure is formed using both the first and second processes.

According to another aspect of the present invention, there is provided a light emitting device comprising a light emitting structure having a first conductive semiconductor, an active layer, and a second conductive layer, wherein a halide compound gas containing a group III element and a group V element source gas react on a substrate to thereby form a semiconductor thin film thereupon in a first process, and at least two types of organometallic gases react on the substrate to thereby form a semiconductor thin film thereupon in a second process, the light emitting structure is formed using both the first and second processes.

The active layer may include at least one layer formed of AlₓIn_{y}Ga_{(1-x-y)}N (0≤x≤1, 0≤y≤1, and 0≤x+y≤1).

The active layer may include at least one layer formed of AlₓIn_{y}Ga_{(1-x-y)}P (0≤x≤1, 0≤y≤1, and 0≤x+y≤1).

The first conductive semiconductor layer may include an n-type GaN layer, the active layer may include a lamination structure having alternating InGaN and GaN layers, and the second conductive semiconductor may include a p-type GaN layer.

The light emitting structure may be formed by further using a third process of forming a semiconductor thin film by molecular beam epitaxy.

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a schematic view illustrating the configuration of a vapor deposition system according to an exemplary embodiment of the present invention;

FIGS. 2 and 3 are schematic views illustrating a process of manufacturing a light emitting device using the vapor deposition system of FIG. 1;

FIG. 4 is a schematic view illustrating the configuration of a vapor deposition system according to a modified embodiment of the embodiment, shown in FIG. 1;

FIG. 5 is a schematic sectional view illustrating an example of a completed light emitting device;

FIGS. 6 through 11 are schematic views illustrating the configuration of an example of a chamber structure applicable to a vapor deposition system according to an exemplary embodiment of the present invention;

FIGS. 12 through 14 are schematic configuration views illustrating another chamber structure applicable to a vapor deposition system according to an exemplary embodiment of the present invention;

FIG. 15A is a diagram illustrating the conduction band energy level of an active layer in a horizontal chamber;

FIG. 15B is a diagram illustrating the conduction band energy level of an active layer grown in a vertical chamber;

FIG. 16 is a view enlarging a region around a cover in a horizontal chamber;

FIG. 17 is a schematic view illustrating the configuration of an example of a batch type chamber applicable to the present invention;

FIG. 18 is a schematic view illustrating the configuration of a vapor deposition system according to another exemplary embodiment of the present invention;

FIG. 19 is a schematic view illustrating the configuration of another example of a chamber structure applicable to a vapor deposition system according to an exemplary embodiment of the present invention;

FIG. 20 is a schematic view illustrating the configuration of a vapor deposition system according to another exemplary embodiment of the present invention; and

FIG. 21 is a schematic view illustrating an example of using light emitting devices being manufactured using a vapor deposition system according to an exemplary embodiment of the present invention.

### DETAILED DESCRIPTION OF THE PREFERRED EMBODIMENT

Exemplary embodiments of the present invention will now be described in detail with reference to the accompanying drawings.

The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions may be exaggerated for clarity, and the same reference numerals will be used throughout to designate the same or like components.

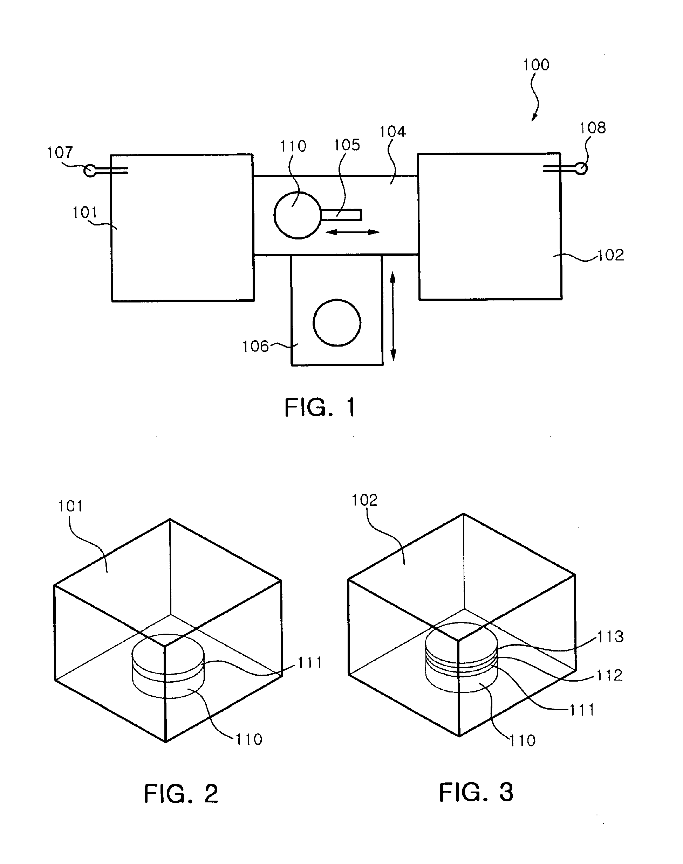

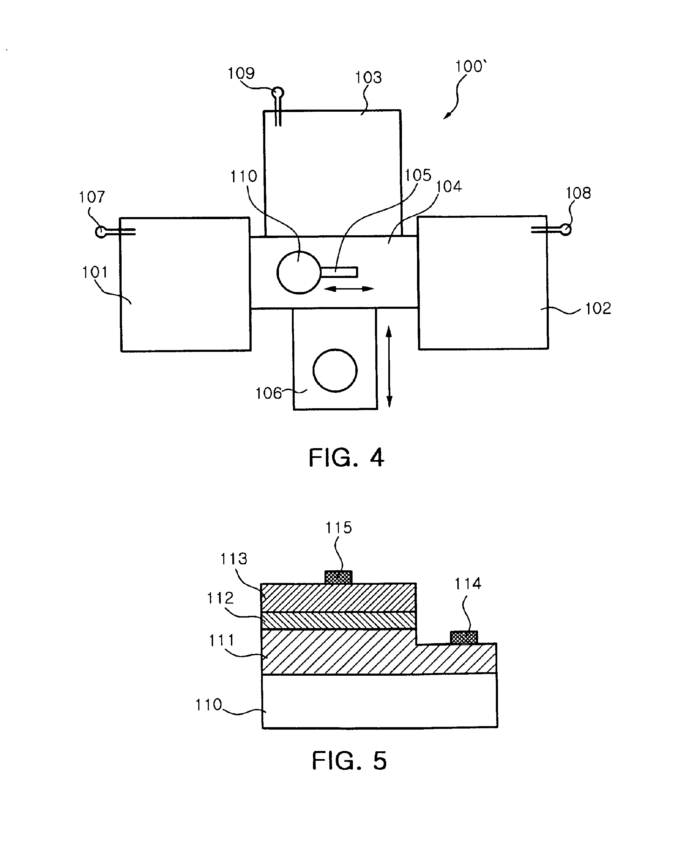

FIG. 1 is a schematic view illustrating the configuration of a vapor deposition system according to an exemplary embodiment of the invention. FIGS. 2 and 3 are schematic views illustrating a process of manufacturing a light emitting device by using the vapor deposition system of FIG. 1. FIG. 4 is a schematic view illustrating the configuration of a vapor deposition system according to a modification of the embodiment, shown in FIG. 1. FIG. 5 is a schematic sectional view illustrating an example of a completed light emitting device.

A vapor deposition system 100 according to this embodiment includes a first chamber 101, a second chamber 102, and a leadblock apparatus 104 connected to the first and second chambers 101 and 102. Gas injection portions 107 and 108 are formed on the first and second chambers 101 and 102, respectively, so as to inject gas from the outside. Here, the first and second chambers 101 and 102 may be deposition chambers using organometallic gases, for example, metal organic chemical vapor deposition (hereinafter, simply referred to as "MOCVD") chambers. Alternatively, one of the first and second chambers 101 and 102 may be an MOCVD chamber, and the other chamber may be a deposition chamber using halide gases, for example, a hydride vapor phase epitaxy (hereinafter, simply refer to as "HVPE") chamber. Further, the first and second chambers 101 and 102 may be chambers using another type of deposition equipment according to MOCVD or HVPE, for example, molecular beam epitaxy (hereinafter, simply refer to as "MBE") chambers. The loadlock apparatus 104 receives a substrate 110 in substantially the same environment inside or outside the first and second chambers 101 and 102 before the substrate 110 is injected into the first and second chambers 101 and 102 or before the substrate 110 is drawn from the first and second chambers 101 and 102. To this end, the loadlock apparatus 104 may be maintained in a vacuum state. Furthermore, the loadlock apparatus 104 may have a transfer robot 105 and a transfer path in order to inject or draw the substrate 110 into or from the first and second chambers 101 and 102. Though not being an indispensible component, a loading unit 106 may be further included to mount the substrate 110 on the vapor deposition system 100.

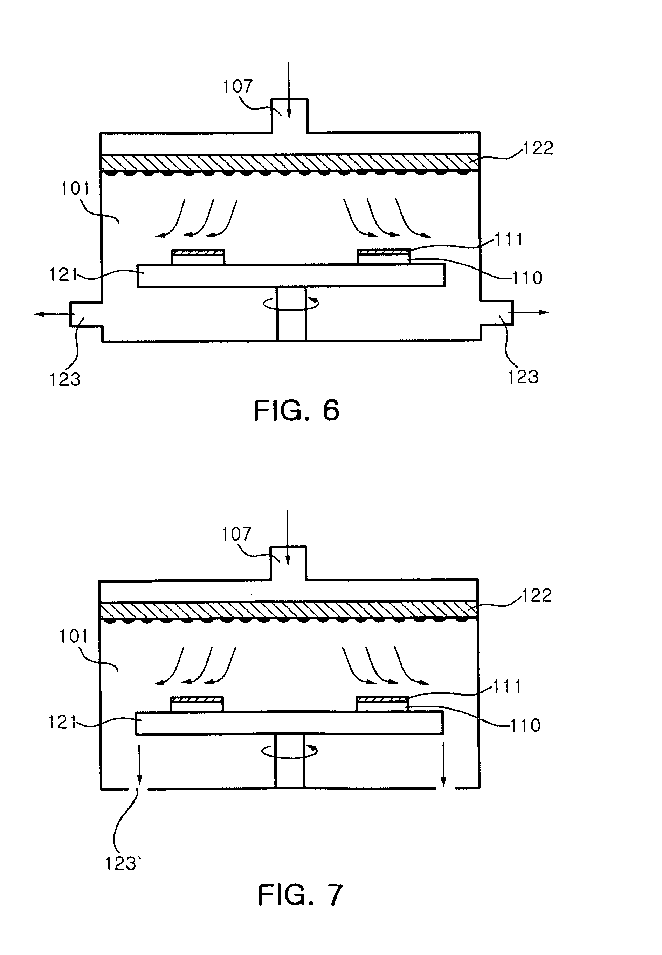

CVD, that is, chemical vapor deposition, refers to a process in which a nonvolatile solid film is formed on a substrate by using reactions between gaseous chemicals containing necessary elements. As the gaseous chemicals enter a reaction chamber, the gaseous chemicals decompose and react on the surface of the substrate being heated at a predetermined temperature, thereby forming a semiconductor thin film. Here, during MOCVD, organometallic gases are used as metal source gases in order to grow a thin film formed of a material such as a nitride semiconductor. According to an HVPE technique, halide gases, such as hydrogen chloride, are injected into the reaction chamber to form a halide compound containing a group III element, the halide compound is supplied to an upper side of the substrate, and the halide compound is reacted with a gas containing a group V element to thereby grow a semiconductor thin film. Specific examples of the MOCVD chamber and the HVPE chamber, applicable to this embodiment, will be described below with reference to FIGS. 6 through 17. An MBE process is one of epitaxy methods of compound semiconductors. According to the MBE process, a semiconductor thin film is formed between a molecular or atomic beam having heat energy and a substrate being maintained at high temperatures. This MBE process may substitute for an HVPE process or an MOCVD process to be described below.

Processes of manufacturing a light emitting device by using the vapor deposition system 100 according to this embodiment will now be described. First, as shown in FIG. 2, the substrate 110 is disposed inside the first chamber 101. A first conductive semiconductor layer 111 is grown on the substrate 110. Here, the first chamber 101 may be an MOCVD chamber or an HVPE chamber. The substrate 110 is provided as a semiconductor growth substrate. As for the substrate 110, for example, a substrate, formed of sapphire, SiC, MgAl₂O₄, MgO, LiAlO₂, LiGaO₂, or GaN, may be used. Here, sapphire is a crystal having hexa-Rhombo R3c type symmetry. Further, sapphire has a lattice constant of 13.001 Å along the c-axis and a lattice distance of 4.765 Å along the a-axis, and has the c-plane (0001), the a-plane(1120), and the r-plane(1102). Here, the c-plane of the sapphire is typically used as a nitride growth substrate since a nitride thin film is relatively easily grown on the c-plane, and is stable at high temperature. The first conductive semiconductor layer 111 may be formed of an n-type nitride semiconductor, for example, AlₓIn_{y}Ga_{(1-x-y)}N (0≤x≤1, 0≤y≤1, and 0≤x+y≤1) doped with Si or the like. The first conductive semiconductor layer 111 may be formed of a material other than a nitride, for example, AlₓIn_{y}Ga_{(1-x-y)}P (0≤x≤1, 0≤y≤1, and 0≤x+y≤1).

After the first conductive semiconductor layer 111 is grown, as shown in FIG. 3, as the substrate 110 is moved into the second chamber 102, a subsequent process is then performed. Here, the substrate 110 may be moved from the first chamber 101 to the second chamber 102 by way of the loadlock apparatus 104 by means of the transfer robot 105. However, in this embodiment, the substrate 110 is not necessarily moved by the transfer robot 105. According to an exemplary embodiment, the loadlock apparatus 104 may be removed. In this case, after the growth of the first conductive semiconductor layer 111 is completed, the substrate 110 can be manually moved.

Like the first chamber 101, the second chamber 102 may be an MOCVD chamber or an HVPE chamber. Even in the case that the first chamber 101 and the second chamber 102 are of the same type, the second chamber 102 may have a different structure from the first chamber 101. For example, the first chamber 101 may be a vertical MOCVD chamber in which source gases are injected in a vertical direction, while the second chamber 102 may be a horizontal MOCVD chamber in which gases are discharged in a direction parallel to the substrate 110. Here, specific examples of the horizontal and vertical MOCVD chambers will be described below. After the substrate 110 is moved into the second chamber 102, as shown in FIG. 3, an active layer 112 and a second conductive semiconductor layer 113 are grown on the first conductive semiconductor layer 111. In this case, for the efficient operation of the vapor deposition system 100, a process of growing the active layer 112 and the second conductive semiconductor layer 113 in the second chamber 102 may be performed at the same time as a process of growing the first conductive semiconductor layer 111 in the first chamber 101.

The second conductive semiconductor layer 113 may be formed of a p-type nitride semiconductor, for example, AlₓIn_{y}Ga_{(1-x-y)}N (0≤x≤1, 0≤y≤1, and 0≤x+y≤1) doped with Mg or AlₓIn_{y}Ga_{(1-x-y)}P (0≤x≤1, 0≤y≤1, and 0≤x+y≤1). The active layer 112, interposed between the first and second conductive semiconductor layers 111 and 113, emits light having a predetermined energy by the recombination of electrons and holes. Further, the active layer 112 may have a multilayer quantum well (MQW) structure formed of alternating quantum well layers and quantum barrier layers. As for the multilayer quantum well (MQW) structure, a multilayer structure formed of AlₓIn_{y}Ga_{(1-x-y)}N (0≤x≤1, 0≤y≤1, and ≤0x+y≤1), for example, an InGaN/GaN structure may be used. Alternatively, a multilayer structure, formed of AlₓIn_{y}Ga_{(1-x-y)}P (0≤x≤1, 0≤y≤1, and 0≤x+y≤1), for example, an InGaP/GaP structure may be used. In terms of the band-gap energy characteristics of materials, this InGaP/GaP structure may be more suitable for emitting red light as compared with a nitride semiconductor.

Since the first conductive semiconductor layer 111, the active layer 112, and the second conductive semiconductor layer 113 may differ in growth temperatures and source gas atmospheres, a separate growth process according to this embodiment may be effectively used. Specifically, the first conductive semiconductor layer 111 may be grown under growth temperature conditions different from those of the active layer 112 and the second conductive semiconductor layer 113. That is, the first conductive semiconductor layer 111 may be grown at higher temperatures than those of the active layer 112 and the second conductive semiconductor layer 113. To this end, the temperature inside the first chamber 102 may be maintained to be higher than the temperature inside the second chamber 101. Specifically, when the first conductive semiconductor layer 111 is formed of, for example, n-type GaN, the first conductive semiconductor layer 111 is grown at a temperature of approximately 1100 to 1300°C. Therefore, the temperature inside the first chamber 101 needs to be correspondingly maintained. The active layer 112 and the second conductive semiconductor layer 113 are grown at temperatures lower than that, that is, at temperatures of approximately 700 to 1100°C. The temperature inside the second chamber 102 is correspondingly maintained. As such, as the temperature inside the second chamber 102 is maintained at a level appropriate for growing the active layer 112, the active layer 112 can be formed to have a desired composition, thereby improving the performance and reliability of a light emitting device. Furthermore, in this embodiment, there is no need to change the temperature inside the second chamber 102 in order to grow the active layer 112 and the second conductive semiconductor layer 113. Therefore, the temperatures inside the first and second chambers 101 and 102 are maintained to be constant, thereby facilitating equipment management and thus reducing deterioration in the apparatus.

Another processing condition is that a doping element source gas atmosphere can be maintained as it is, one of the advantages of separately growing semiconductor layers forming a light emitting device by using two or more chambers. In this embodiment, it is described that the first and second conductive semiconductor layers 111 and 113 and the active layer 112 are separately grown. However, the invention is not limited thereto. For example, the first conductive semiconductor layer 111 may be grown using both first and second chambers 101 and 102. In the same manner, the active layer 112 may be grown using both first and second chambers 101 and 102. For example, the quantum barrier layers and the quantum well layers may be separately grown.

Another advantage of using the vapor deposition system, described in this embodiment, is that the operational capability and productivity of the vapor deposition system can be improved. Specifically, when semiconductor layers forming a light emitting device, that is, the first and second conductive semiconductor layers 111 and 113 and the active layer 112 are grown together in each of the first and second chambers 101 and 102, the first and second chambers 101 and 102 operate for relatively long periods of time. The burden of source gases and the time taken to perform manufacturing processes when a failure occurs are therefore relatively greater than those according to a separate growth method according to this embodiment. Furthermore, according to this separate growth method, since a one-time growth process can be completed in a relatively short period of time in a single piece of deposition equipment, a maintenance process for the equipment, which is applicable before subsequent growth processes, may be flexibly performed. In this embodiment, a separate growth process of the semiconductor layers 111, 112, and 113 by using the two chambers 101 and 102 is described. However, the number of chambers may be increased as the need arises.

Specifically, like a vapor deposition system 100', shown in FIG. 4, a third chamber 103 is further included. The active layer 112 may be grown in the second chamber 102, while the second conductive semiconductor layer 113 may then be grown in the third chamber 103. In this embodiment, the reaction chambers of the first, second, and third vapor deposition chambers 101, 102, and 103 may be maintained according to temperature conditions of semiconductor layers to be grown therein. Specifically, as described above, the temperature inside the reaction chamber of the first chamber 101 may be maintained at a temperature of approximately 1100 to 1300°C. In order to grow the active layer 112 having a InGaN/GaN quantum well structure, the temperature inside the second chamber 102 may be maintained at a temperature of approximately 700 to 900°C. When the second conductive semiconductor layer 113 is formed of, for example, p-type GaN, the temperature inside the reaction chamber of the third chamber 103 may be maintained at a temperature of approximately 900 to 1100°C. In this embodiment, the semiconductor layers 111, 112, and 113, forming a light emitting structure, are separately respectively grown using the above-described three different chambers according to a separate growth method to thereby realize further improvement in crystalline quality. Furthermore, in addition to temperature conditions, the inside of the reaction chamber of the first chamber 101 may be maintained as an atmosphere of an n-type doping element gas. In the same manner, the inside of the third chamber 103 may be maintained as an atmosphere of a p-type doping element gas. Therefore, there is no need to change a doping element gas during the growth process.

After the growth of the second conductive semiconductor layer 113 is completed, the first and second electrodes 115 and 114 are formed on the second conductive semiconductor layer 113 and a mesa-etched region of the first conductive semiconductor layer 111. However, this method of forming the first and second electrodes 115 and 114 is only one example. Electrodes may be formed at various positions within the light-emitting structure having the first conductive semiconductor layer 111, the active layer 112, and the second conductive semiconductor layer 113. For example, after the substrate 110 is removed, the first electrode 115 may then be formed on the surface of the first conductive semiconductor layer 111, which is thereby exposed.

Hereinafter, specific examples of the above-described chambers and chambers suitable for growing individual semiconductor layers will be described in more detail. First, examples of the first chamber 101 being used to grow the first conductive semiconductor layer 111 may include an MOCVD chamber, an HVPE chamber, an MBE chamber, and the like. Here, the MOCVD chamber being used as the first chamber 101 will be described. FIGS. 6 through 11 are schematic views illustrating the configuration of chamber structures applicable to a vapor deposition system according to an exemplary embodiment of the invention. First, referring to FIG. 6, as for the first chamber 101 in which the first conductive semiconductor layer 111 is grown, source gases are injected from above the substrate 110. Here, the first chamber 101 may be referred to as a vertical chamber 101. As the source gases are injected from above the substrate 110, the first conductive semiconductor layer 111 may be grown. As an example of growth conditions, when the first conductive semiconductor layer 111 has n-type GaN, the source gas may be TMG, NH3, SiH4 or the like, and a growth temperature of approximately 900 to 1300°C may be set. The first chamber 101 may be configured so as to have a gas injection portion 107, a susceptor 121, a gas distributor 122, and a gas exhaust unit 123. In this embodiment, the gas exhaust unit 123 is formed in a lateral direction of the first chamber 101. However, as in a modification, as shown in FIG. 7, a gas exhaust unit 123' may be formed in the lower part of the first chamber 101.

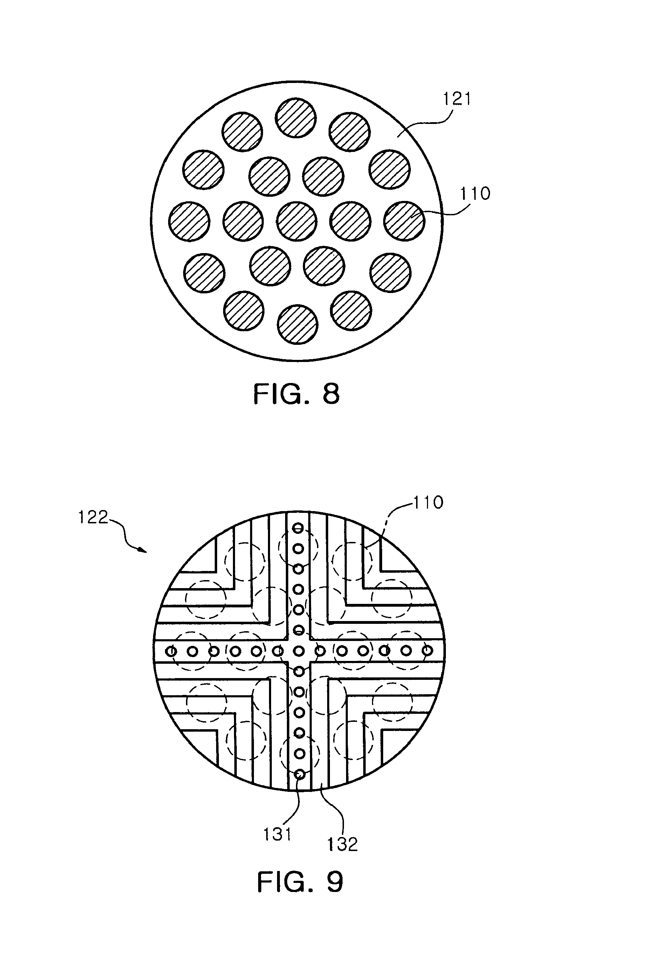

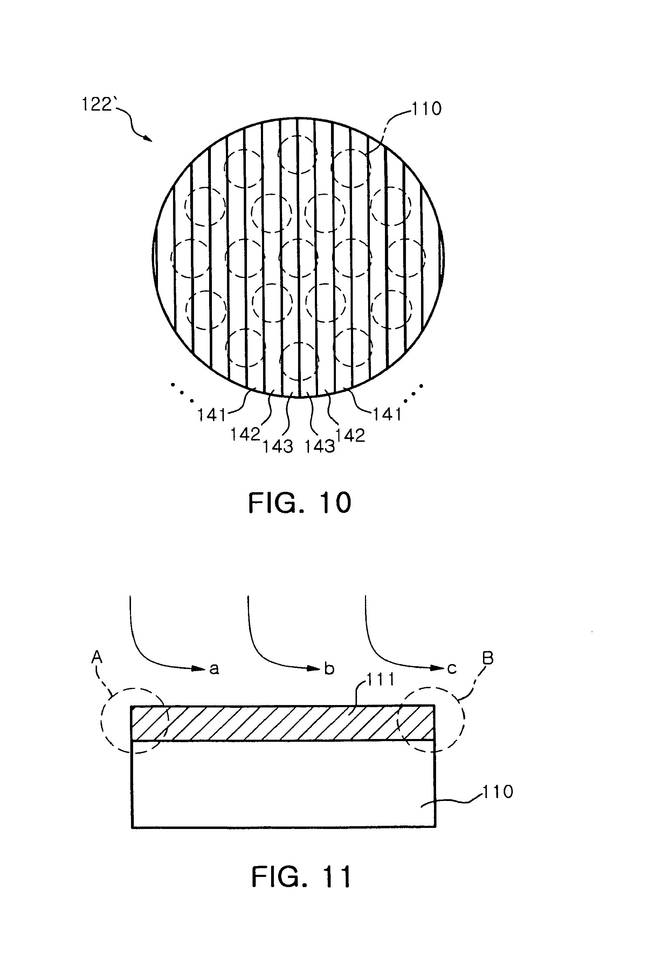

As shown in FIG. 8, one or more substrates 110 are disposed on the susceptor 121, which may perform a rotary motion. The gas distributor 122 is disposed above the susceptor 121 on which the substrate 110 is disposed so that gas distributor 122 can discharge gas downwards. An example of the susceptor 121 having this structure is illustrated in FIGS. 9 and 10. Referring to FIG. 9, as an example of the gas distributor 122, there are two types of gas paths as viewed from top thereof, that is, a first gas pipe 131, formed into a hole, and a second gas pipe 132 being bent. Different types of gases may be injected through the first and second gas pipes 131 and 132. For example, an organometallic gas, such as TMG or TMI, may be injected through the gas first gas pipe 131. A group V source gas such as NH₃ may be injected through the second gas pipe 132. Then, as shown in FIG. 10, as another example, a gas distributor 122' may have a plurality of striped gas pipes. For example, different types of source gases may be injected through first, second, and third gas pipes 141, 142, and 143 into which the gas distributor 122' is divided. Specifically, in order to grow n-type GaN, TMG may be injected through the first gas pipe 141, NH₃ may be injected through the second gas pipe 142, and SiH₄ may be injected through the third gas pipe 143.

As shown in FIG. 11, in the above-described vertical chamber 101, gases a, b, and c of different types may be injected from above the substrate 110, so that two regions A and B along both edges of the semiconductor layer 111 may have different compositions. Such a difference in composition of the semiconductor layer 111 may occur within the substrate 110. A difference in composition may also occur between the same semiconductor layer 111 and a semiconductor layer grown on another substrate disposed on the susceptor. In particular, the difference in composition becomes more distinct when source gases are changed in order to grow different kinds of semiconductor layers. However, the vertical chamber 101 has advantages over a horizontal chamber to be described below in terms of equipment maintenance since particles are less likely to be generated through reactions between source gases in an area other than the substrate 110, even though a growth process is performed for relatively long periods of time. Therefore, the vertical chamber 101 is appropriate to grow the first conductive semiconductor layer 111 that requires a lengthy growth process, since the first conductive semiconductor layer 111 is thicker than other layers.

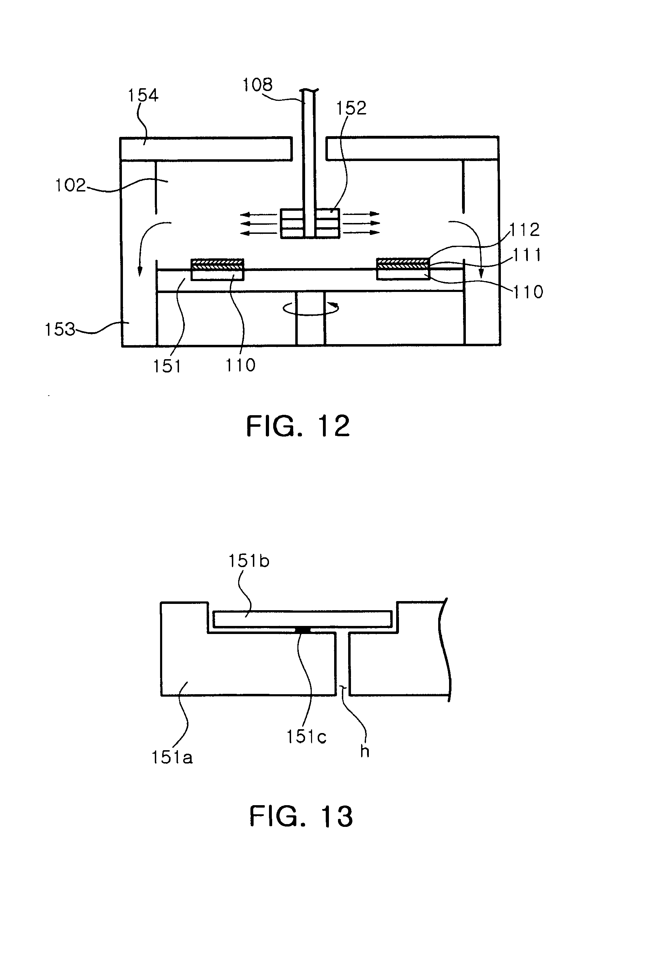

Then, in this embodiment, the second chamber 102, being used to grow the active layer 112 and the second conductive semiconductor layer 113, will be described. FIGS. 12 through 14 are views illustrating an example of another chamber structure applicable to a vapor deposition system. Referring to FIG. 12, in the second chamber 102, gas sources are injected from the gas distributor 152 in a direction parallel to the substrate 110. The second chamber 102 may be referred to as a horizontal chamber 102. Therefore, the source gases are injected from above the substrate 110 to thereby grow the active layer 112. As an example of growth conditions, when the active layer 112 has an InGaN/GaN structure, TMG, TMI, and NH₃ may be all injected when InGaN is grown. When GaN is grown, TMG and NH₃ may be injected except for TMI. Here, the inside of the second chamber 102 may be maintained at the growth temperature of the active layer 112, for example, at a temperature of approximately 700 to 900°C. Though not shown in the drawing, a second conductive semiconductor layer may further be grown in the second chamber 102 or a growth process thereof may be performed in another deposition chamber.

The second chamber 102 may be configured so as to have a gas injection portion 108, a susceptor 151, a gas distributor 152, a gas exhaust unit 153, and a cover 154. The source gases injected through the gas injection portion 108 may be discharged through the gas distributor 152 in a direction parallel to the substrate 110. To this end, as shown in FIG. 12, the gas distributor 152 may be disposed at the central area of the second chamber 102 to thereby discharge gases towards the outside of the second chamber 102. However, the position of the gas distributor 152 is not limited thereto. Though not shown in the drawing, the gas distributor 152 may be disposed at the side of the second chamber 102 to discharge gases inwards. The gases having passed through the substrate 110 may be discharged through the gas exhaust unit 153 formed at the edge of the second chamber 102 to the outside.

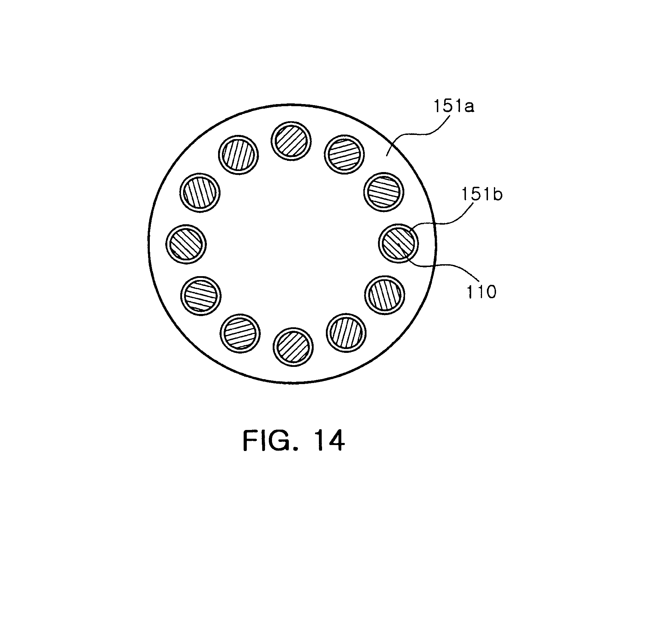

FIGS. 13 and 14 are views illustrating an example of the susceptor 151. FIG. 13 is a partially enlarged view, and FIG. 14 is an upper plan view. The susceptor 151 may be divided into a main disc 151a and auxiliary discs 151b. Here, all of the main disc 151a and the auxiliary discs 151b may be configured so as to perform a rotary motion. The auxiliary discs 151b may be connected to pins 151c formed on the main disc 151a. Here, the substrates 110 may be arranged into a circle around the gas distributor 15. Additionally, in order to facilitate the rotary motion of the auxiliary disc 151b, gases may be injected through holes h between the main disc 151a and the auxiliary discs 151b.

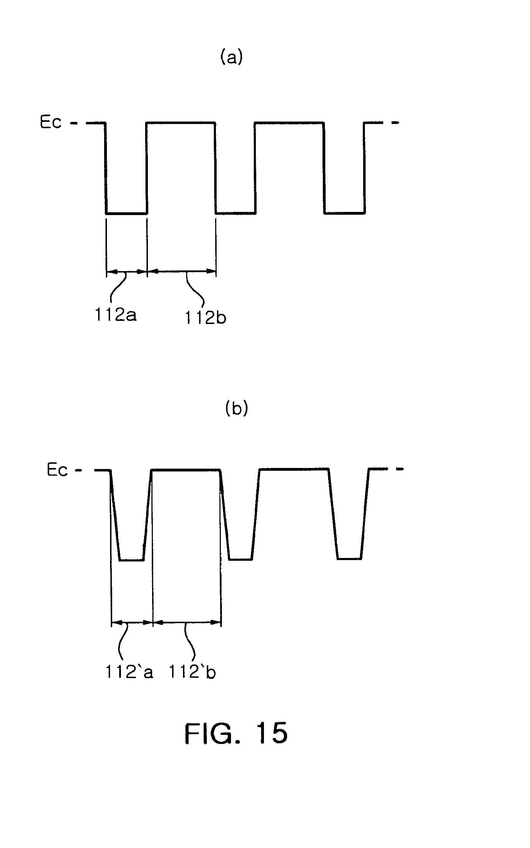

The horizontal chamber 102 may have advantages over the above-described vertical chamber 101 in terms of growing a thin film having a desired composition since source gases may be relatively uniformly injected into the substrate 110. Therefore, the active layer 112 and the second conductive semiconductor layer 113, greatly affecting the performance of the light emitting device, are grown by using the horizontal chamber 101 to thereby increase luminous efficiency. FIGS. 15A and 15B are diagrams showing the conduction band energy level of an active layer. In FIG. 15A, an active layer, grown in a horizontal chamber, is shown. In FIG. 15B, an active layer, grown in a vertical chamber, is shown. Referring to FIGS. 15A and 15B, as for the active layer grown in the horizontal chamber, there is a distinct boundary between the quantum well layer 112a and the quantum well layer 112b, so that relatively excellent carrier confinement of the quantum well layer 112a can be obtained. On the other hand, as for the active layer grown in the vertical chamber, band gap energy and composition distributions with gradients may be shown at regions around the interface between the quantum well layer 112b' and the quantum well layer 112b, thereby relatively reducing the carrier confinement of the quantum well layer 112b'.

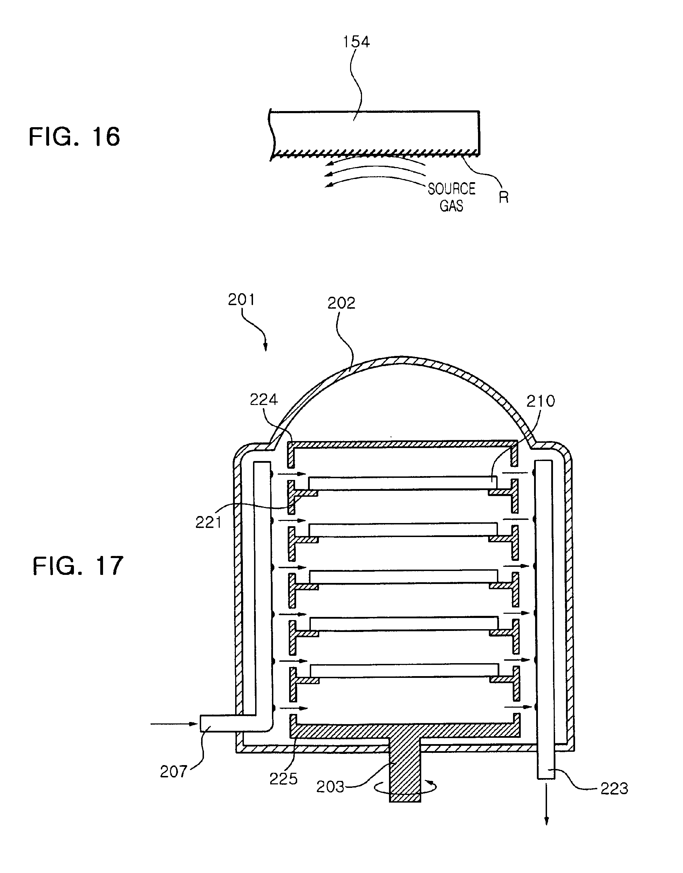

However, as shown in FIG. 16, in the horizontal chamber 102, source gases may react at the cover 154 or at the ceiling connected thereto, so that a reaction region R formed of particles may be generated. This reaction region R may cause wasted time and excessive costs associated with equipment maintenance. Therefore, it may be desirable to reduce processing times in the horizontal chamber 102 so as to be as short as possible. As described above, since the first conductive semiconductor layer 111 has a relatively great thickness, it takes a long time to grow the first conductive semiconductor layer 111, and the crystalline quality thereof is not greatly affected by a growth method. Therefore, it is desirable to use the vertical chamber 101. As for the active layer 112 and the second conductive semiconductor layer 113 having a relatively small thickness and greatly affecting the performance of a light emitting device, it is also desirable to use the horizontal chamber 102 in order to grow the active layer 112 and the second conductive semiconductor layer 113. As such, in this embodiment, a single device is grown by using two or more chambers according to the separate growth method to thereby improve the operational capability of the equipment. Further, deposition systems conforming to the characteristics of individual layers of the light emitting device are used to thereby increase luminous efficiency and enhance the productivity of equipment.

Meanwhile, in the above-described embodiment, the chamber structure in which substrates are arranged on the susceptor in a horizontal direction is described. However, the invention is not limited thereto. A batch type chamber in which substrates are arranged in a thickness direction may also be used. FIG. 17 is a schematic view illustrating one example of a batch type chamber applicable to an exemplary embodiment of the invention. Referring to FIG. 17, the batch type chamber 201 may include a main body 202, a gas injection portion 207, susceptors 221, a gas exhaust unit 223, and upper and lower plates 224 and 225. Substrates 210 are arranged on the susceptors 221 while bottom surfaces of the substrates 210 may be exposed. Therefore, semiconductor thin films may be grown on both sides of each of the substrates 210. Source gases may be injected into the substrates 210 through a plurality of paths formed between upper and lower plates 224 and 225, and may then be discharged through the substrates 210 via the gas exhaust unit 223. Here, the upper and lower plates 224 and 225 and the susceptors 221 may be formed integrally with each other, and may be connected to a shaft 203 transferring a rotary motion. The substrates 210 inside the batch type chamber 201 are arranged in the thickness direction thereof. FIG. 17 illustrates a case in which five substrates 210 are arranged inside the batch type chamber 201. However, the number of substrates 210 may be higher than five, which may be advantageous for mass production of light emitting devices. Here, the above-described MOCVD, HVPE, and MBE chambers may all be used as the batch type chamber 201.

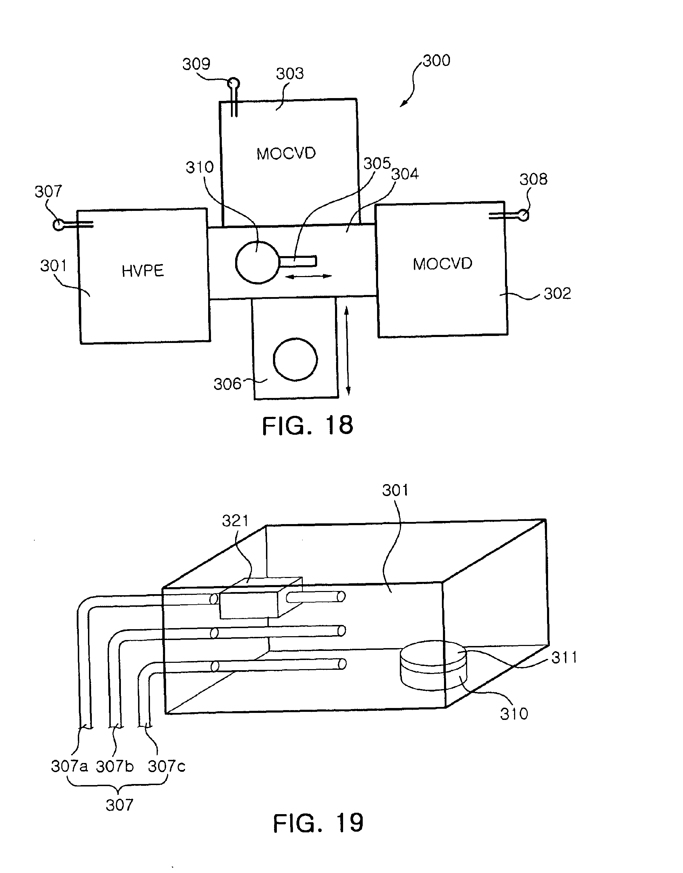

FIG. 18 is a schematic view illustrating the configuration of a vapor deposition system according to another exemplary embodiment of the invention. Referring to FIG. 18, a vapor deposition system 300 includes first, second, and third chambers 301, 302, and 303 on which gas injection portions 307, 308, and 309 are respectively formed. In order to inject or draw a substrate 310 into or from the first, second, and third chambers 301, 302, and 303, a loadlock apparatus 304 having a transfer robot 305 and a transfer path may be connected to the first, second, and third chambers 301, 302, and 303. Furthermore, the vapor deposition system 300 may include a loading unit 306 though it is not necessarily used.

In this embodiment, the first chamber 301 is an HVPE chamber, which may be used to grow a first conductive semiconductor layer. Furthermore, the second and third chambers 302 and 303 may be MOCVD chambers. A chamber structure among the above-described chamber structures may be used to grow another layer forming the light emitting device according to a separate growth. Since the structure of the MOCVD chamber is described above, referring to FIG. 19, an example of the HVPE chamber will be described. However, an MBE chamber may be used instead of an HVPE chamber or an MOCVD chamber. Alternatively, all three kinds of chambers may be used. That is, the concept of separate growth, being proposed in this invention, is that different growth processes may be performed in order to manufacture a light emitting device.

FIG. 19 is a view illustrating the configuration of another example of a chamber structure applicable to a vapor deposition system according to an exemplary embodiment of the invention. The gas injection portion 307 is connected to the first chamber 301 in order to inject source gases. Here, the gas injection portion 307 may be divided into first, second, and third gas injection portions 307a, 307b, and 307c. A halide gas, such as HCl, is injected into the first chamber 301 through the first gas injection portion 307a. During this process, the halide gas passes through a storage portion 321, in which a group III element, for example, Ga, is contained. A halide compound (GaCl) gas is thereby created, which may be supplied to the upper side of the substrate 310. A gas containing a group V element, for example, NH₃, is injected into the first chamber 301 through the second gas injection portion 307b. This gas reacts with the halide compound to thereby grow group III to V compound semiconductor thin films. Doping source gases, for example, an n-type source gas, such as SiH₄ or Si₂H₄, may be injected through the third gas injection portion 307c to thereby form the first conductive semiconductor layer 311.

This HVPE process may result in a lower crystalline semiconductor thin film structure than that of an MOCVD process, and can provide a higher growth rate than that of the MOCVD process. Therefore, as described above, the first conductive semiconductor layer 311, which needs to have a relatively great thickness, can be grown to a sufficient thickness in a relatively short period of time. Then, by using a separate growth method, being proposed in this invention, an active layer and a second conductive semiconductor layer are grown so as to have an excellent crystalline structure by an MOCVD process to thereby prevent a reduction in luminous efficiency.

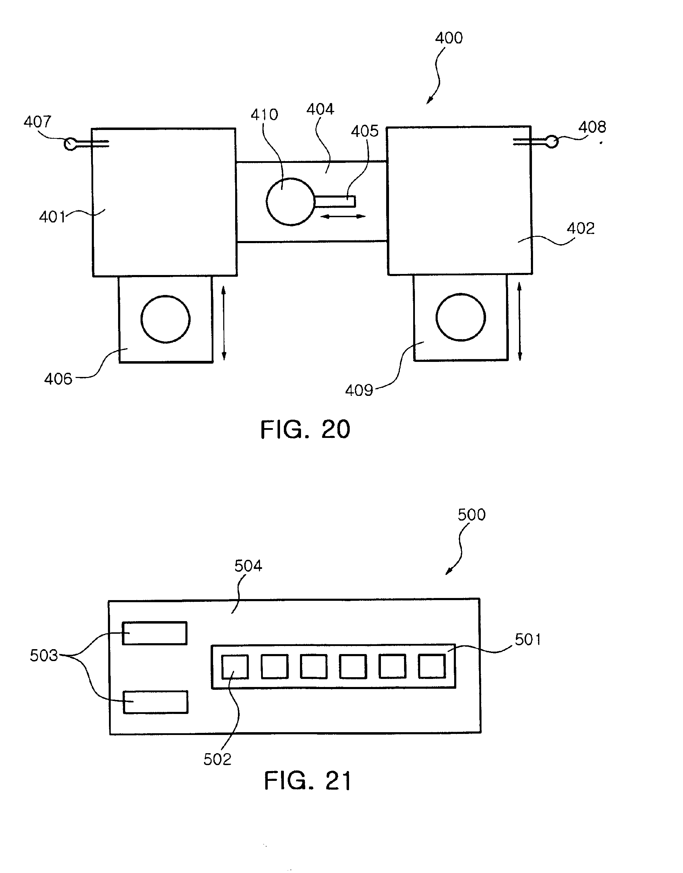

FIG. 20 is a schematic view illustrating a configuration of a vapor deposition system according to another exemplary embodiment of the invention. Referring to FIG. 20, in a vapor deposition system 400 according to this embodiment, chambers are not separate from each other in a single system, and at least two vapor deposition systems are connected through a loadlock apparatus 404. Here, the vapor deposition systems include vapor deposition chambers 401 and 402, gas injection portions 407 and 408, and loading units 406 and 409, respectively. As for the vapor deposition chambers 401 and 402, the above-described various structures using HVPE and MOCVD chambers may be used, and a separate growth method may also be applied. As described above, a substrate 410 may be moved by a transfer robot 405 provided in the loadlock apparatus 404. Alternatively, the substrate 410 may be moved manually instead of using the transfer robot 405.

FIG. 21 is a schematic view illustrating the configuration of an example of using light emitting devices being manufactured by using a vapor deposition system according to an exemplary embodiment of the invention. Referring to FIG. 21, a light emitting apparatus 500 includes a light emitting device module 501, a structure 504 having the light emitting device module 501 disposed therein, and a power supply unit 503. One or more light emitting devices 502, being manufactured according to the above-described method, being proposed in this invention, are disposed in the light emitting device module 501. The power supply unit 503 includes a power supply, a constant current supply, a controller, and the like. Furthermore, the power supply unit 503 may further include a feedback circuit comparing the amount of light being emitted from the light emitting device 502 and a predetermined light amount, and a memory device storing information about desired luminance or color rendering. This light emitting apparatus 500 may be used in indoor lighting apparatuses such as lamps and plane light sources, or outdoor lighting apparatuses such as streetlights, signboards, and signs. Furthermore, the light emitting apparatus 500 may also be used in various transportation lighting apparatuses, such as automobiles, ships, and aircraft. The light emitting apparatus 500 may further be used in home appliances, such as TVs and refrigerators, or in medical equipment.

As set forth above, according to exemplary embodiments of the invention, a vapor deposition system can lead to excellent crystalline quality of a semiconductor layer being grown using the system to thereby improve the performance of a light emitting device. Furthermore, the operational capability and productivity of a vapor disposition system can be improved while preventing deterioration in an apparatus.

While the present invention has been shown and described in connection with the exemplary embodiments, it will be apparent to those skilled in the art that modifications and variations can be made without departing from the spirit and scope of the invention as defined by the appended claims.
**The following is a list of further preferred embodiments of the invention:**
Embodiment 1: A vapor deposition system comprising:
   a first chamber having a first susceptor and at least one gas distributor discharging a gas in a direction parallel to a substrate disposed on the first susceptor; and
   a second chamber having a second susceptor and at least one second gas distributor arranged above the second susceptor to discharge a gas downwards.
Embodiment 2: A vapor deposition system comprising:
   a first chamber having a first susceptor and at least one gas distributor, the first chamber in which a halide compound gas containing a group III element and a group V element source gas, through the first gas distributor, react on a substrate arranged on the first susceptor to thereby form a semiconductor thin film thereupon; and
   a second chamber including a second susceptor and at least one second gas distributor, the second chamber in which at least two types of organometallic gases, through the second gas distributor, react on a substrate arranged on the second susceptor to thereby form a semiconductor thin film thereupon.
Embodiment 3: The vapor deposition system of embodiment 1 or 2, further comprising a loadlock apparatus connected to the first and second chambers and having a transfer robot and a transfer path.
Embodiment 4: The vapor deposition system of embodiment 1 or 2, wherein the first and second chambers are provided in a single vapor deposition system.
Embodiment 5: The vapor deposition system of embodiment 1 or 2, wherein the first and second chambers are provided in different vapor deposition systems.
Embodiment 6: The vapor deposition system of embodiment 1 or 2, wherein at least one of the first and second chambers is a batch type chamber.
Embodiment 7: The vapor deposition system of embodiment 1, wherein the first gas distributor discharges a gas in a direction from an inside to an outside of the first chamber.
Embodiment 8: The vapor deposition system of embodiment 7, wherein the first gas distributor is arranged in a central region inside the first chamber.
Embodiment 9: The vapor deposition system of embodiment 7, wherein a plurality of substrates are arranged on the first susceptor, and the plurality of substrates are arranged into a circle around the first gas distributor.
Embodiment 10: The vapor deposition system of embodiment 2, wherein the first chamber is an HVPE (hydride vapor phase epitaxy) chamber, and the second chamber is an MOCVD (metal organic chemical vapor deposition) chamber.
Embodiment 11: The vapor deposition system of embodiment 2, further comprising a molecular beam epitaxy (MBE) chamber in addition to the first and second chambers.
Embodiment 12: A method of manufacturing a light emitting device, the method comprising growing a first conductive semiconductor layer, an active layer, and a second conductive semiconductor layer on a substrate to thereby form a light emitting structure,
   wherein when source gases, discharged from above the substrate, react on the substrate to thereby form a semiconductor thin film thereupon in a first process, and the source gases, discharged in a direction parallel to the substrate, react on the substrate to thereby form a semiconductor thin film thereupon in a second process,
   the light emitting structure is formed using both the first and second processes.
Embodiment 13: A method of manufacturing a light emitting device, the method comprising growing a first conductive semiconductor layer, an active layer, and a second conductive semiconductor layer on a substrate in a sequential manner to thereby form a light emitting structure,
   wherein when a halide compound gas containing a group III element and a group V element source gas react on the substrate to thereby form a semiconductor thin film thereupon in a first process, and two types of organometallic gases react on the substrate to thereby form a semiconductor thin film thereupon in a second process,
   the light emitting structure is formed using both the first and second processes.
Embodiment 14: A method of manufacturing a light emitting device, the method comprising growing a first conductive semiconductor layer, an active layer, and a second conductive semiconductor layer on a substrate to thereby form a light emitting structure,
   wherein a semiconductor thin film is formed using a first vapor deposition system having a first chamber and a first loadlock apparatus in a first process, and a semiconductor thin film is formed using a second vapor deposition system having a second chamber and a second loadlock apparatus in a second process,
   the light emitting structure is formed using both the first and second processes.
Embodiment 15: The method of any one of embodiments 12 through 14, wherein a growth temperature of the first conductive semiconductor layer is higher than that of the second conductive semiconductor layer.
Embodiment 16: The method of any one of embodiments 12 through 14, wherein the active layer comprises at least one layer formed of InₓGa₍₁₋ₓ₎N (1≤x≤0).
Embodiment 17: The method of any one of embodiments 12 through 14, wherein the active layer comprises at least one layer formed of InₓGa₍₁₋ₓ₎P (1≤x≤0).
Embodiment 18: The method of any one of embodiments 12 through 14, wherein the first conductive semiconductor layer comprises an n-type GaN layer,
   the active layer comprises a lamination structure having alternating InGaN and GaN layers, and
   the second conductive semiconductor layer comprises a p-type GaN layer.
Embodiment 19: The method of embodiment 12, wherein the first conductive semiconductor layer is formed using the first process.
Embodiment 20: The method of embodiment 12, wherein the active layer and the second conductive semiconductor layer are formed using the second process.
Embodiment 21: The method of embodiment 12, wherein the first conductive semiconductor layer is formed using both the first and second processes.
Embodiment 22: The method of embodiment 12, wherein the active layer is formed using both the first and second processes.
Embodiment 23: The method of embodiment 22, wherein the active layer comprises a quantum well layer and a quantum barrier layer, and the quantum well layer and the quantum barrier layer are separately formed using the first and second processes, different from each other.
Embodiment 24: The method of embodiment 13, wherein the first conductive semiconductor layer is formed using the first process.
Embodiment 25: The method of embodiment 13, wherein the active layer and the second conductive semiconductor layer are formed using the second process.
Embodiment 26: The method of embodiment 13, wherein the first conductive semiconductor layer is formed using both the first and second processes.
Embodiment 27: The method of embodiment 13, wherein the light emitting structure is formed by further using a third process of forming a semiconductor thin film by molecular beam epitaxy.
Embodiment 28: The method of embodiment 14, wherein at least one of the first and second vapor deposition systems has a batch type chamber in which the substrate is arranged in a thickness direction.
Embodiment 29: The method of embodiment 14, wherein one of the first conductive semiconductor layer, the active layer, and the second conductive semiconductor layer is grown in the first chamber, while another layer is grown in the second chamber.
Embodiment 30: The method of embodiment 14, wherein the first conductive semiconductor layer is grown in the first chamber, and the first chamber is maintained at a growth temperature and a gas atmosphere of the first conductive semiconductor layer.
Embodiment 31: The method of embodiment 14, wherein the active layer and the second conductive layer are grown in the second chamber, and the second chamber is maintained at growth temperatures and gas atmospheres of the active layer and the second conductive layer.
Embodiment 32: The method of embodiment 14, further comprising a third vapor deposition system including a third chamber and a third loadlock apparatus,
   wherein the first conductive semiconductor layer is grown in the first chamber, the active layer is grown in the second chamber, and the second conductive semiconductor layer is grown in the third chamber.
Embodiment 33: The method of embodiment 14, wherein the first conductive semiconductor layer is formed using both the first and second processes.
Embodiment 34: The method of embodiment 14, wherein the active layer is formed using both the first and second processes.
Embodiment 35: The method of embodiment 34, wherein the active layer comprises a quantum well layer and a quantum barrier layer, and the quantum well layer and the quantum barrier layer are separately formed using the first and second processes, different from each other.
Embodiment 36: A light emitting device comprising a light emitting structure having a first conductive semiconductor, an active layer, and a second conductive layer,
   wherein when source gases, discharged from above a substrate, react on a semiconductor growth substrate to thereby form a semiconductor thin film thereupon in a first process, and source gases, discharged in a direction parallel to the substrate, react on the semiconductor growth substrate to thereby form a semiconductor thin film thereupon in a second process,
   the light emitting structure is formed using both the first and second processes.
Embodiment 37: A light emitting device comprising a light emitting structure having a first conductive semiconductor, an active layer, and a second conductive layer,
   wherein a halide compound gas containing a group III element and a group V element source gas react on a semiconductor growth substrate to thereby form a semiconductor thin film thereupon in a first process, and at least two types of organometallic gases react on the semiconductor growth substrate to thereby form a semiconductor thin film thereupon in a second process,
   the light emitting structure is formed using both the first and second processes.
Embodiment 38: The light emitting device of embodiment 36 or 37, wherein the active layer comprises at least one layer formed of AlₓIn_{y}Ga_{(1-x-y)}N (0≤x≤1, 0≤y≤1, and o≤x+y≤1).
Embodiment 39: The light emitting device of embodiment 36 or 37, wherein the active layer comprises at least one layer formed of AlₓIn_{y}Ga_{(1-x-y)}P (0≤x≤1, 0≤y≤1, and 0≤x+y≤1).
Embodiment 40: The light emitting device of embodiment 36 or 37, wherein the first conductive semiconductor layer comprises an n-type GaN layer,
   the active layer comprises a lamination structure having alternating InGaN and GaN layers, and
   the second conductive semiconductor comprises a p-type GaN layer.
Embodiment 41: The light emitting device of embodiment 37, wherein the light emitting structure is formed by further using a third process of forming a semiconductor thin film by molecular beam epitaxy.

## Claims

1. A vapor deposition system comprising:
a first chamber having a first susceptor and at least one gas distributor discharging a gas in a direction parallel to a substrate disposed on the first susceptor; and
a second chamber having a second susceptor and at least one second gas distributor arranged above the second susceptor to discharge a gas downwards,
wherein at least one of the first and second chambers is a batch type chamber in which a plurality of substrates are arranged in a thickness direction thereof.

2. The vapor deposition system of claim 1, further comprising a loadlock apparatus connected to the first and second chambers and having a transfer robot and a transfer path.

3. The vapor deposition system of claim 1, wherein the first gas distributor is arranged in a central region inside the first chamber.

4. The vapor deposition system of claim 1, wherein a plurality of substrates are arranged on the first susceptor, and the plurality of substrates are arranged into a circle around the first gas distributor.
